# EUROPÄISCHE PATENTSCHRIFT

(11) **EP 4 226 500 B1**
(45) Veröffentlichungstag und Bekanntmachung des Hinweises auf die Patenterteilung: **22.10.2025**
(21) Anmeldenummer: 21786465.1
(22) Anmeldetag: 01.10.2021
(51) Int. Cl.: H03K 17/18, H02J 1/10, H02J 9/06, H02M 3/158

(54) **STROMVERSORGUNGSVORRICHTUNG UND VERFAHREN ZUM ÜBERPRÜFEN EINES FELDEFFEKTTRANSISTORS EINER SOLCHEN STROMVERSORGUNGSVORRICHTUNG**
POWER SUPPLY DEVICE AND METHOD FOR CHECKING A FIELD-EFFECT TRANSISTOR OF SUCH A POWER SUPPLY DEVICE
DISPOSITIF D'ALIMENTATION ÉLECTRIQUE ET PROCÉDÉ DE CONTRÔLE D'UN TRANSISTOR À EFFET DE CHAMP D'UN TEL DISPOSITIF D'ALIMENTATION ÉLECTRIQUE

(30) Priorität: 05.10.2020 DE 102020126016
(43) Veröffentlichungstag der Anmeldung: 16.08.2023
(73) Patentinhaber: Weidmüller Interface GmbH & Co. KG, 32758 Detmold (DE)
(72) Erfinder: PLÖGER, Matthias, 32657 Lemgo (DE); BUSCHKAMP, Michael, 32791 Lage (DE); SCHÜRMANN, Klaus, 32791 Lage (DE); BLOME, Tobias, 32825 Blomberg (DE)
(74) Vertreter: Kleine, Hubertus
(86) Internationale Anmeldenummer: PCT/EP2021/077149
(87) Internationale Veröffentlichungsnummer: WO 2022/073883

(56) Entgegenhaltungen:
- EP-A1- 1 863 176
- WO-A2-2005/020286
- US-A1- 2002 039 034

## Beschreibung

Die Erfindung betrifft eine Stromversorgungsvorrichtung mit einer Stromversorgungseinheit, der mindestens ein als aktive Diode geschalteter Feldeffekttransistor nachgeschaltet ist. Die Erfindung betrifft weiterhin ein Verfahren zur Überprüfung mindestens eines als aktive Diode geschalteten Feldeffekttransistors in einer Stromversorgungsvorrichtung.

Um Rückströme in Stromversorgungsvorrichtungen zu verhindern, wird in der Regel in Serie zur angeschlossenen Last eine Diode geschaltet. Von besonderer Bedeutung ist eine derartige Diode, wenn zwei oder mehrere Stromversorgungsvorrichtungen mit ihren Ausgängen parallel verschaltet werden, um eine Last zu versorgen. Eine Versorgung einer Last aus parallel verschalteten Stromversorgungsvorrichtungen wird in der Praxis z.B. dann eingesetzt, wenn ein höherer Strom benötigt wird, als eine einzelne, zur Verfügung stehende Stromversorgungsvorrichtung liefern kann. Ein anderer Grund kann in einer gewünschten redundanten Versorgung liegen, durch die eine Last auch bei Ausfall einer der Stromversorgungsvorrichtungen sicher betrieben werden kann.

Häufig wird die genannte Diode bereits innerhalb einer Stromversorgungsvorrichtung angeordnet. Sie ist dann der eigentlichen Stromversorgungseinheit, die die Ausgangsspannung aufbaut und den Ausgangsstrom bereitstellt, nachgeschaltet. Wegen der beschriebenen Funktionalität, dass bei parallel geschalteten Stromversorgungsvorrichtungen die eine und/oder die andere die Last versorgen kann, wird die Diode auch als "ORing-Diode" bezeichnet.

Da diese ORing-Dioden im Leistungspfad der Last liegen, tragen sie den gesamten von der Stromversorgungsvorrichtung bereitgestellten Strom. Bei einem Spannungsabfall von etwa 0,7 Volt (V) in Durchlassrichtung einer Silizium-Diode führt dieses bei Stromversorgungsvorrichtungen mit einem höheren Ausgangsstrom von einigen oder einigen 10 Ampere (A) zu nicht unerheblichen Leistungsverlusten.

Um diese Leistungsverluste zu verringern, ist es z.B. aus den Druckschriften EP 1 863 176 A1 und US 2002/0039034 A1 bekannt, anstelle einer passiven Silizium-Diode einen oder mehrere geschaltete(n) Feldeffekttransistor(en) (FET) einzusetzen, der oder die mit einer zusätzlichen Ansteuerschaltung versehen wird, welche wiederum abhängig sein kann von der Höhe einer am Ausgang der Stromversorgungsvorrichtung anliegenden Spannung relativ zur eingestellten Ausgangsspannung der Stromversorgungseinheit. Bei Einsatz eines geeigneten Feldeffekttransistors, insbesondere eines MOSFET-Transistors (Metalloxid-FET) können im leitenden Zustand Durchgangswiderstände im Bereich von Milliohm erreicht werden, wodurch der Spannungsabfall auf wenige Millivolt (mV) oder wenige 10 mV verringert werden kann und die Verlustleistung entsprechend reduziert werden kann, während, bei geeigneter Ansteuerung, gleichzeitig die Funktion einer Diode gegeben ist.

Insbesondere bei Stromversorgungsvorrichtungen, die zum redundanten Einsatz vorgesehen sind, ist dabei eine Überprüfung der korrekten Funktion des Feldeffekttransistors gewünscht und sinnvoll, um die Redundanz der Stromversorgung zu garantieren. Wenn z.B. durch einen dauerhaft leitenden Feldeffekttransistor die Stromversorgungsvorrichtungen nicht mehr voneinander entkoppelt sind, könnte ein Ausfall einer Stromversorgungsvorrichtungen auch die anderen beeinträchtigen.

In der Druckschrift US 7,038,433 B2 bzw. der inhaltsgleichen Druckschrift WO 2005/020286 A2 ist eine Ansteuerschaltung für einen Feldeffekttransistor zur Verwendung als aktive Diode beschrieben. Neben der Funktion zur Ansteuerung des Feldeffekttransistors zum Erzielen der aktiven Diodenfunktion umfasst die Schaltung einen Testschaltkreis, der ein Warnsignal ausgibt, wenn trotz abgeschaltetem Feldeffekttransistor ein Spannungsabfall über seiner Schaltstrecke einen vorgegebenen Wert unterschreitet. Ein zu kleiner Spannungsabfall wird als Zeichen angesehen, dass die Schaltstrecke des Transistors durchgeschmolzen ist und einen dauerhaft geringen Widerstand aufweist.

Das beschriebene Verfahren liefert für eine im Einzelbetrieb laufende Stromversorgungsvorrichtung zuverlässige Ergebnisse. Bei einem Parallelbetrieb von mindestens zwei ausgangsseitig zusammengeschalteten Stromversorgungsvorrichtungen kann ein gemessener und unterhalb des Schwellwerts liegender Spannungsabfall jedoch seinen Ursprung auch darin haben, dass die von beiden Stromversorgungsvorrichtungen bereitgestellten Spannungen in ihrer Höhe soweit übereinstimmen, dass kein Spannungsabfall messbar ist. In diesem Fall würde fälschlicherweise auf einen defekten ORing-FET geschlossen.

Es ist daher eine Aufgabe der vorliegenden Erfindung, ein Testverfahren für einen derartigen ORing-FET zu beschreiben, das zuverlässige Testergebnisse liefert und ausschließt, dass ein eigentlich korrekt funktionierender Feldeffekttransistor als defekt erkannt wird. Es ist eine weitere Aufgabe, eine Stromversorgungsvorrichtung bereitzustellen, die zur Durchführung eines derartigen Testverfahrens eingerichtet ist.

Diese Aufgabe wird durch ein Testverfahren bzw. eine Stromversorgungsvorrichtung mit den Merkmalen des jeweiligen unabhängigen Anspruchs gelöst. Vorteilhafte Ausgestaltungen und Weiterbildungen sind Gegenstand der abhängigen Ansprüche.

Ein erfindungsgemäßes Verfahren zum Überprüfen mindestens eines als aktive Diode geschalteten Feldeffekttransistors, der innerhalb einer Stromversorgungsvorrichtung einem Ausgang einer Stromversorgungseinheit nachgeschaltet ist, weist erfindungsgemäß die folgenden Schritte auf: Es wird ein nicht vollständig leitender, insbesondere sperrender Zustand des Transistors eingestellt und ein erster Wert eines Spannungsabfalls über einer Schaltstrecke des Feldeffekttransistors bei einer ersten eingestellten Spannung der Stromversorgungseinheit gemessen. Anschließend wird eine von der ersten Spannung abweichende zweite Spannung der Stromversorgungseinheit eingestellt und ein zweiter Wert des Spannungsabfalls über der Schaltstrecke des Feldeffekttransistors bei dieser zweiten Spannung gemessen. Ein Defekt des Feldeffekttransistors wird festgestellt und signalisiert, falls der Wert des erste Spannungsabfalls und der zweite Wert des Spannungsabfalls beide in ihrem Betrag kleiner als ein vorgegebener positiver erster Schwellenwert sind, oder falls der erste Wert des Spannungsabfalls und/oder der zweite Wert des Spannungsabfalls größer als ein vorgegebener zweiter positiver Schwellenwert sind, wobei der zweite Schwellenwert größer ist als der erste Schwellenwert.

Falls der Wert des Spannungsabfalls zwischen dem ersten und dem zweiten Schwellenwert liegt, deutet das auf ein Kommutieren des Laststroms von der Schaltstrecke auf eine Body-Diode hin. Die Body-Diode ist eine intrinsische Diode des Feldeffekttransistors, die der Schaltstrecke parallel geschaltet ist. In ihrer Durchlassrichtung übernimmt die Body-Diode einen Stromfluss, auch wenn der Feldeffekttransistor nicht leitend geschaltet ist. In der Regel ist ein als aktive Diode genutzter Schalttransistor bei Stromversorgungseinrichtungen gerade so angeordnet, dass die Body-Diode eine ORing-Funktion innehat, dann allerdings mit dem Siliziumdioden-typischen Spannungsabfall von z.B. etwa 0,7 V und nicht mit dem vorteilhaften kleineren Spannungsabfall, der mit einem leitend geschalteten Feldeffekttransistor erzielt werden kann.

Auch wenn im Rahmen dieser Anmeldung von einem oder dem Feldeffekttransistor gesprochen wird, bezieht sich dieses auch auf eine Anordnung mehrerer synchron angesteuerter Transistoren. Bezüglich ihrer Schaltstrecke können parallel geschaltete Feldeffekttransistoren zum Erreichen einer höheren Stromtragfähigkeit eingesetzt werden. Bezüglich ihrer Schaltstrecke seriell geschaltete Feldeffekttransistoren können eingesetzt werden, um ein sichereres Schaltverhalten zu erzielen.

Anstelle oder zusätzlich zu einer intrinsischen Body-Diode kann auch eine extern zum Feldeffekttransistor angeordnete Diode, insbesondere eine Schottky-Diode eingesetzt werden.

Die Schwellenwerte können insbesondere für eine Überprüfung einer Anordnung mit intrinsischer oder externer parallel zum Feldeffekttransistor geschalteter Diode beispielsweise auf 0,3 V und 2 V festgelegt sein. Wenn die zweitgenannte Bedingung in einer der beiden Messungen erfüllt ist, bedeutet das, dass der Feldeffekttransistor zwar wie gewünscht sperrt, aber auch seine Body-Diode nicht leitend ist. Dieses ist ein seltener aber möglicher Fehlerfall, der auf diese Weise erfasst wird. In einer vorteilhaften Ausgestaltung des Verfahrens beträgt der erste Schwellenwert etwa 0,3 V. Weiter vorteilhaft beträgt der zweite Schwellenwert mindestens etwa 1,5 V, insbesondere etwa 2V.

Falls der Spannungsabfall in der ersten Messung den ersten Schwellenwert nicht übersteigt, kann dieses an einem Kurzschluss in der Schaltstrecke des Feldeffekttransistors liegen. Ein Übergang des Stroms auf die Body-Diode kann aber auch deswegen nicht erfolgt sein, weil am Ausgang eine Spannung von extern, z. B. durch eine parallel geschaltete weitere Stromversorgungsvorrichtung aufrechterhalten wird. Das Abändern der Nennspannung vor der zweiten Messung des Spannungsabfalls führt jedoch zu unterschiedlichen Ausgangsspannungen der beteiligten Stromversorgungsvorrichtungen. Falls der Feldeffekttransistor dann korrekt abgeschaltet hat und der Laststrom auf die Body-Diode kommutiert ist, zeigt sich dieses in einer entsprechend großen Spannungsdifferenz. Wird allerdings auch in dieser zweiten Messung kein über dem ersten Schwellenwert liegender Spannungsabfall gemessen, kann erfindungsgemäß ein defekter Feldeffekttransistor erkannt und signalisiert werden.

Als Stromversorgungseinheit einer erfindungsgemäßen Stromversorgungsvorrichtung kann z.B. ein Wechselstrom (AC) / Gleichstrom (DC)-Wandler, häufig auch als Netzteil bezeichnet, eingesetzt werden. Im Rahmen der Anmeldung sind unter dem Begriff einer Stromversorgungseinheit ebenso, aber nicht ausschließlich auch DC/DC Wandler sowie Batterie- und Puffermodule zur unterbrechungsfreien Stromversorgung zu verstehen.

In einer vorteilhaften Ausgestaltung des Verfahrens ist die zweite Spannung um etwa 1 V größer als die erste Spannung. Ein solcher fester Betrag, um den die Nennspannung der Stromversorgungseinheit geändert wird, ist technisch einfach umsetzbar und in der Regel ausreichend, um nach der Messung des zweiten Werts des Spannungsabfalls Aussagen darüber machen zu können, ob der gemessene erste Wert des Spannungsabfalls lediglich aufgrund einer extern anliegenden Spannung oder tatsächlich wegen eines defekten Feldeffekttransistors unterhalb des ersten Schwellenwerts lag.

In einer dazu alternativen Variante des Verfahrens ist die zweite Spannung um etwa den zweiten Schwellenwert größer als eine gemessene Spannung an Ausgangsanschlüssen der Stromversorgungsvorrichtung. Bei diesen Messbedingungen kann eine korrekte Übernahme des Stroms auf die intrinsische bzw. externe parallele Diode besonders zuverlässig erfasst werden.

In einer weiteren vorteilhaften Ausgestaltung wird die Messung der beiden Spannungsabfälle und deren Auswertung wiederholt durchgeführt, um einen möglichen Defekt des Transistors sicher zu erfassen. Dabei kann vorgesehen sein, dass ein Defekt des mindestens einen Feldeffekttransistors erst dann signalisiert wird, wenn er in einer vorgegebenen Anzahl von Wiederholungen, beispielsweise erst nach drei oder mehr Wiederholungen, festgestellt wird. So wird eine hohe Positiv-Sicherheit für die Defekterkennung erreicht.

Bevorzugt liegt zwischen zwei aufeinanderfolgenden Wiederholungen des Verfahrens eine Wartezeit, die insbesondere im Hinblick auf ihre Länge eine Zufallskomponente umfasst. Die Zufallskomponente kann z.B. anhand einer individuellen Kennung der Stromversorgungsvorrichtung, insbesondere einer Seriennummer, berechnet werden.

Die Zufallskomponente verhindert, dass im Fall von mindestens zwei baugleichen und ausgangsseitig parallel geschalteten Stromversorgungsvorrichtungen ein Defekt des Feldeffekttransistors vermeintlich erkannt wird, weil die beiden Stromversorgungsvorrichtungen das zuvor beschriebene Verfahren ausführen und entsprechend genau synchron beim Ablaufen dieses Verfahrens ihre Nennspannung für die Messung des zweiten Spannungsabfalls ändern. Dieser Fall ist nicht unwahrscheinlich, wenn zwei gleiche Stromversorgungsvorrichtungen redundant ausgangsseitig, aber auch eingangsseitig zusammengeschaltet sind und zum gleichen Zeitpunkt mit Eingangsspannung beaufschlagt werden, also gleichzeitig eingeschaltet werden. Mit einem gleichzeitigen Start der Stromversorgungsvorrichtungen läuft auch das anmeldungsgemäße Verfahren zunächst synchron ab. Die Zufallskomponente verhindert, dass bei Wiederholung der Messung wiederum die Stromversorgungsvorrichtungen ihre Messungen mit gleicher Zeitstruktur durchführen.

Eine erfindungsgemäße Stromversorgungsvorrichtung der eingangs genannten Art zeichnet sich durch eine Steuereinheit aus, die zur Durchführung des zuvor beschriebenen Verfahrens eingerichtet ist. Es ergeben sich die im Zusammenhang mit dem Verfahren beschriebenen Vorteile. Die das Verfahren ausführende Steuereinheit kann dabei Teil einer Steuereinrichtung der Stromversorgungseinheit sein.

Der mindestens eine Feldeffekttransistor ist Teil eines ORing-Moduls, wobei die Stromversorgungseinheit und das ORing-Modul in getrennten Gehäusen oder auch einem gemeinsamen Gehäuse angeordnet sein können.

Die Erfindung wird nachfolgend anhand von Ausführungsbeispielen mithilfe von Figuren näher erläutert. Die Figuren zeigen:
- Figur 1: ein schematisches Blockschaltbild einer Stromversorgungsvorrichtung;
- Figur 2: ein Flussdiagramm eines ersten Ausführungsbeispiels eines Testverfahrens zur Überprüfung eines ORing-Feldeffekttransistors; und
- Figur 3: ein Flussdiagramm eines zweiten Ausführungsbeispiels eines Überwachungsverfahrens für einen ORing- Feldeffekttransistor.

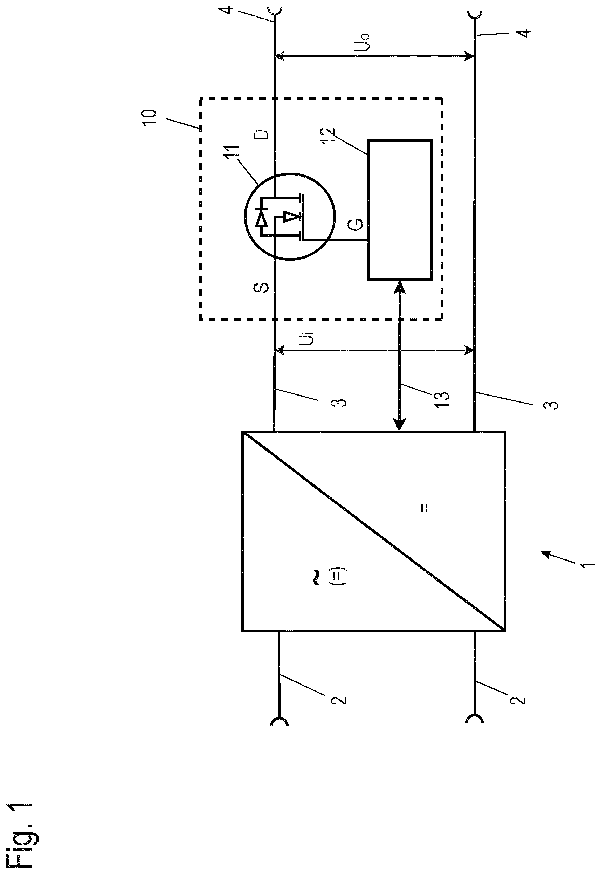

In Figur 1 ist in einem Blockschaltbild eine Stromversorgungsvorrichtung gezeigt, die eine Stromversorgungseinheit 1 und ein sogenanntes ORing-Modul 10 umfasst. Es wird angemerkt, dass die beiden genannten Einheiten, die Stromversorgungseinheit 1 und das ORing-Modul 10, sowohl in einem Gehäuse der Stromversorgungsvorrichtung integriert angeordnet sein können als auch in separaten Gehäusen.

Die Stromversorgungseinheit 1 wandelt eine Eingangsspannung in eine Ausgangsspannung um, wobei die Eingangsspannung je nach Modell Gleich- und/oder Wechselspannung sein kann. Häufig wird eine Lichtnetz-Wechselspannung als Eingangsspannung verwendet. In dem Fall wird die Stromversorgungseinheit 1 auch als Netzteil bezeichnet. Als Ausgangsspannung ist eine in der Regel auf einen vorgegebenen Wert, die sogenannte Nennspannung, geregelte Ausgangsgleichspannung vorgesehen. In einem regulären Betrieb der Stromversorgungseinheit 1 weicht die Ausgangsspannung in ihrer Höhe von der Nennspannung nur dann wesentlich ab, wenn ein Ausgangsstrom der Stromversorgungseinheit einen Maximalwert überschreitet.

Die Stromversorgungsvorrichtung weist Eingangsanschlüsse 2 auf, die auch die Eingänge der Stromversorgungseinheit 1 darstellen und über die ein Eingangsstrom für die Stromversorgungseinheit 1 zugeführt wird. Im vorliegenden Beispiel sind zwei Eingangsanschlüsse 2 vorhanden, da die Stromversorgungseinheit 1 eingangsseitig z.B. von einphasigem Wechselstrom versorgt wird. Die Anzahl der Eingangsanschlüsse 2 kann auch größer als zwei sein, beispielsweise bei einem Anschluss der Stromversorgungsvorrichtung an ein 3-phasiges Wechselstromnetz.

Die Ausgangsspannung der Stromversorgungseinheit 1 steht an einem hier zweipoligen Ausgang 3 zur Verfügung. Die Stromversorgungsvorrichtung weist Ausgangsanschlüsse 4 auf, an denen eine Last anschließbar ist, die von der Stromversorgungseinheit 1 versorgt wird.

Zwischen der Stromversorgungseinheit 1 und den Ausgangsanschlüssen 4, also der Last, ist das ORing-Modul 10 geschaltet. Dieses weist einen Feldeffekttransistor 11 auf, nachfolgend als FET 11 bezeichnet, über dessen Schaltstrecke (i.e. zwischen einem Source-Anschluss S und einem Drain-Anschluss D) der gesamte Laststrom fließt. Im dargestellten Ausführungsbeispiel ist der FET 11 ein n-Kanal-Anreicherungstyp, der ohne Ansteuerung sperrend ist. Grundsätzlich ist es möglich, auch andere Typen oder Kombinationen von einem oder mehreren Feldeffekttransistoren einzusetzen.

Im dargestellten Beispiel ist der negative Ausgang der Stromversorgungseinheit 1 unmittelbar mit dem negativen Ausgangsanschluss 4 der Stromversorgungsvorrichtung verbunden, wohingegen der positive Ausgang 3 über den FET 11 an den positiven Ausgangsanschluss 4 der Stromversorgungsvorrichtung geführt ist. In alternativen Ausgestaltungen kann der positive Ausgangsanschluss 4 unmittelbar mit der Stromversorgungseinheit 1 verbunden sein und der negative Ausgangsanschluss 4 über den Feldeffekttransistor. In diesem Fall sind ggf. Schwellenwerte mit angepasster Höhe zu verwenden.

Das ORing-Modul 10 weist eine Steuereinheit 12 auf, die den FET 11 über seinen Gate-Eingang G steuert. Um die ORing-Funktion des ORing-Moduls 10 zu gewährleisten, werden dazu von der Steuereinheit 12 die Spannungen am Ausgangsanschluss 4 mit den Spannungen am Ausgang 3 der Stromversorgungseinheit 1 verglichen. Diese Spannungen sind in der Figur 1 als Uᵢ und Uₒ dargestellt. Die Spannung Uᵢ stellt die Ausgangsspannung der Stromversorgungseinheit 1 und damit die Eingangsspannung für das ORing-Modul dar. Die Spannung Uₒ ist die an den Ausgangsanschlüssen 4 anliegende Spannung. Wird die Spannung Uₒ größer als die Spannung Uᵢ, sperrt die Steuereinheit 12 den FET 11, um einen Stromrückfluss von den Ausgangsanschlüssen 4 in die Stromversorgungseinheit 1 zu verhindern. Entsprechende Messleitungen, die zur Steuereinheit 12 führen, sind in der Figur 1 aus Gründen der einfacheren Darstellung nicht wiedergegeben.

Im Schaltsymbol des FET 11 ist zwischen dem Source-Anschluss S und dem Drain-Anschluss D des FETs 11 eine Diode eingezeichnet, die auch als Body-Diode bezeichnet wird und bei Feldeffekttransistoren intrinsisch ist. Die Diode ist so orientiert, dass der FET 11 auch ohne Ansteuerung seines Gate-Anschlusses G eine ORing-Funktion innehat, dann allerdings mit dem Siliziumdioden-typischen Spannungsabfall von circa 0,7 Volt und nicht mit dem vorteilhaften kleineren Spannungsabfall, der mit einem leitend geschalteten FET 11 erzielt werden kann.

Zusätzlich zur Ansteuerung des Gates des FET 11 weist die Steuereinheit 12 im dargestellten Ausführungsbeispiel einen Steueranschluss 13 auf, der mit der Stromversorgungseinheit 1 gekoppelt ist und über den die Ausgangsspannung Uᵢ der Stromversorgungseinheit 1 variiert werden kann. Diese Funktionalität wird im Rahmen des nachfolgend beschriebenen Testverfahrens eingesetzt. Auch ist in einer alternativen Ausgestaltung denkbar, dass die im ORing-Modul 10 angeordnete Steuereinheit 12 die Ansteuerung des FET 11 im Hinblick auf die ORing-Funktion vornimmt, wobei der Steueranschluss 13 es ermöglicht, den Schaltzustand des FET 11 im Rahmen des nachfolgend beschriebenen Testverfahrens unabhängig davon zu beeinflussen. Es wird angemerkt, dass insbesondere bei einer Integration des ORing-Moduls 10 zusammen mit der Stromversorgungseinheit 1 die Funktion der Steuereinheit 12 auch ganz oder teilweise von einer Steuereinheit der Stromversorgungseinheit 1 übernommen werden kann.

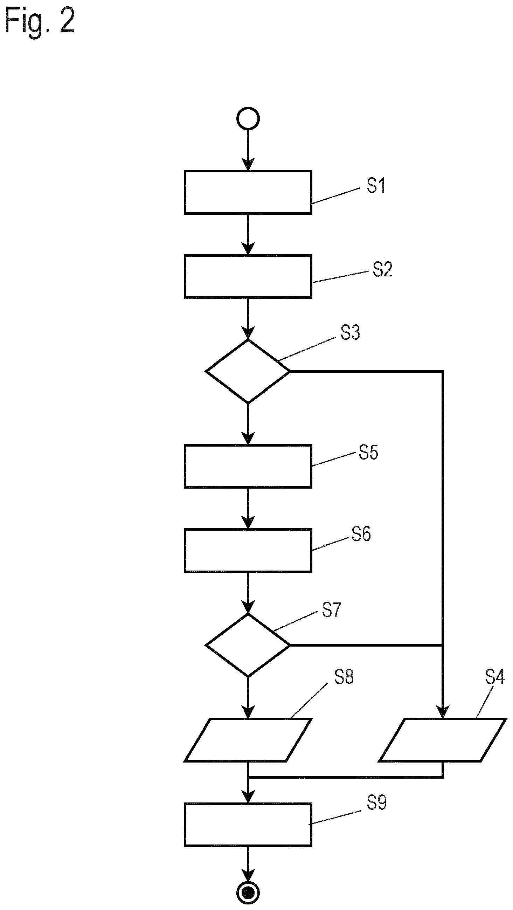

In Figur 2 ist ein Ausführungsbeispiel eines Verfahrens zum Überprüfen der Funktionsfähigkeit eines Feldeffekttransistors, der in einem ORing-Modul als aktive Diode eingesetzt wird, in Form eines Flussdiagramms dargestellt. Das Verfahren kann beispielsweise in der Stromversorgungsvorrichtung gemäß Figur 1 durchgeführt werden und wird beispielhaft an dem Aufbau gemäß Figur 1 und unter Verwendung der dort angegebenen Bezugszeichen erläutert.

Es wird davon ausgegangen, dass bei Durchführung des Verfahrens sich die Stromversorgungseinheit 1 in einem regulären Betrieb befindet und an ihrem Ausgang 3 eine voreingestellte Spannung, die Nennspannung, als Spannung Uᵢ bereitstellt. Das Verfahren geht darüber hinaus von keiner weiteren Voraussetzung aus. Insbesondere kann die zu überprüfende Stromversorgungsvorrichtung ohne Last betrieben werden oder alleine oder in einer Parallelverschaltung mit mindestens einer weiteren Stromversorgungsvorrichtungen eine Last betreiben. Wenn die Stromversorgungsvorrichtung mit einem Stromfluss aktiv an einer Versorgung der Last beteiligt ist, wird der FET 11 des ORing-Moduls 10 von der Steuereinheit 12 über den Gate-Anschluss G leitend angesteuert. In einer alternativen Ausgestaltung des Verfahrens kann dieses auch vorab durch entsprechende Messungen abgefragt werden.

In einem ersten Schritt S1 des Verfahrens wird der FET 11 in einen gesperrten Zustand gebracht, beispielsweise dadurch, dass der Gate-Anschluss G durch die Steuereinheit 12 nicht mehr angesteuert wird. Dieses kann durch eine entsprechende Ansteuerlogik innerhalb der Steuereinheit 12 unmittelbar erzielt werden. Falls die Stromversorgungsvorrichtung in einem Parallelverbund betrieben wird, kann ein sperrender Zustand des FET 11 auch dadurch erreicht werden, dass die Nennspannung der Stromversorgungseinheit 1 um beispielsweise ein oder mehr Volt abgesenkt wird, wodurch das ORing-Modul 10 eine Betriebssituation erkennt, in der der Feldeffekttransistor 11 gesperrt wird, um Rückströme zu vermeiden. In dem Fall sperrt die Steuereinheit 12 den FET 11 durch ihre ORing-Funktionalität. In einem folgenden Schritt S2 wird eine über der Schaltstrecke (Source-Drain-Strecke) des FET 11 abfallende Spannung ΔU= Uᵢ - Uₒ ermittelt, beispielsweise aus Messung der einzelnen Spannungen Uᵢ und U_{o.} ΔU wird nachfolgend als Spannungsdifferenz oder Spannungsabfall bezeichnet.

Danach wird in einem nächsten Schritt S3 überprüft, ob der Betrag |ΔU| der gemessene Spannungsdifferenz ΔU größer als ein erster positiver Schwellenwert U₁ oder gleich diesem ist, der im Bereich von etwa 0,3 Volt liegt. Wenn das so ist, hat das Abschalten des FET 11 dazu geführt, dass der Laststrom nun über die Body-Diode des FET 11 fließt, die mit einem entsprechenden Spannungsabfall verbunden ist, oder die Body-Diode einen Stromfluss in die Stromversorgungseinheit 1 verhindert. Dieses ist jedoch ein Zeichen dafür, dass die eigentliche Schaltstrecke des FET 11 funktionsfähig ist und insbesondere kein Kurzschlussverhalten zeigt, was sie nach einem Durchschmelzen (auch Durchlegieren genannt) des FET 11 tun würde.

Wird für den Betrag |ΔU| >= U₁ detektiert, verzweigt das Verfahren daher zu einem Schritt S4, in dem angezeigt wird, dass der FET 11 funktionstüchtig ist. Das Verfahren wird danach mit einem Schritt S9 fortgeführt, in dem der Feldeffekttransistor 11 wieder leitend geschaltet wird, so dass seine Schaltstrecke den Laststrom entsprechend verlustarm trägt.

Falls im Schritt S3 festgestellt wurde, dass die gemessene Spannungsdifferenz ΔU im Betrag kleiner als der angegebene erste Schwellenwert U₁ ist, kann zunächst keine Aussage über die korrekte Funktion des FET 11 gemacht werden. Erfindungsgemäß wird in einem folgenden Schritt S5 in dem Fall die Nennspannung der Stromversorgungseinheit 1 und damit die Ausgangsspannung der Stromversorgungseinheit Uᵢ, beispielsweise über den Steuerausgang 13, um einen bestimmten Betrag verändert und insbesondere angehoben, beispielsweise um ein Volt.

Nach gegebenenfalls einer Wartezeit, die die Stromversorgungseinheit 1 benötigt, um die angeforderte geänderte Ausgangsspannung Uᵢ korrekt bereitstellen zu können, wird in einem Schritt S6 die Messung des Schritts S2 wiederholt, also wieder die Spannungsdifferenz ΔU über der Schaltstrecke des FET 11 bestimmt. Daraufhin wird erneut überprüft, ob diese Spannungsdifferenz größer als der vorgegebene positive erste Schwellenwert U₁ ist. Wenn das in diesem Fall gegeben ist, verzweigt das Verfahren wiederum zum Schritt S4, um die korrekte Funktion des FET 11 zu signalisieren.

Hintergrund ist, dass der Unterschied im Ergebnis der Messungen in den Schritten S2 und S6 zeigt, dass ein Übergang des Stroms auf die Body-Diode in den Schritten S2/S3 nicht erfolgte, weil am Ausgang die Spannung Uₒ von extern, z. B. durch eine parallel geschaltetes weitere Stromversorgungsvorrichtung aufrechterhalten wurde. Nach einem Anheben der Nennspannung unterscheiden sich die Ausgangsspannungen der beteiligten Stromversorgungsvorrichtung allerdings. Falls der FET 11 korrekt abgeschaltet hat und der Laststrom auf die Body-Diode kommutiert ist, zeigt sich dieses in einer Spannungsdifferenz ΔU, die im Betrag nicht kleiner als der erste Schwellenwert ist, weswegen das Verfahren in dem Fall zum Schritt S4 verzweigt.

Wenn im Schritt S6 jedoch trotz der angehobenen Nennspannung auch keine im Betrag über dem ersten Schwellenwert liegende Differenzspannung ΔU ermittelt werden konnte, also trotz des Anhebens der Nennspannung keine Stromübernahme auf die Body-Diode erfolgt ist, deutet dieses auf einen Kurzschluss in der Schaltstrecke des Feldeffekttransistors 11 hin, der entsprechend als defekt anzusehen ist. Dieses wird nach der Auswertung der Differenzspannung ΔU in Schritt S7 in einem folgenden Schritt S8 signalisiert.

Im folgenden Schritt S8 wird neben der Signalisierung eines defekten FETs die Nennspannung der Stromversorgungseinheit 1 auf die vorherige Nennspannung zurückgesetzt, die zu Beginn des Verfahrens eingestellt war und das Verfahren mit dem Schritt S9, in dem der Feldeffekttransistor 11 wiederum angesteuert wird, beendet.

Die im Schritt S8 angegebene Signalisierung kann beispielsweise in Form einer Signalanzeige, z. B. einer entsprechenden Leuchtdiode, am ORing-Modul 10 bzw. der Stromversorgungsvorrichtung angezeigt werden. Alternativ ist auch eine Absetzung einer Datennachricht über ein Kommunikationsnetz, mit dem die Stromversorgungsvorrichtung verbunden ist, als Signalisierung anzusehen.

Bei entsprechender Ausgestaltung des Verfahrens können die Schritte S1 bis S8 vorteilhaft in einer Zeit von wenigen Millisekunden (ms) bis maximal 10 ms durchgeführt werden. Dieses ist vorteilhaft, wenn die Stromversorgungsvorrichtung zur Versorgung von Industriegeräten eingesetzt wird. Diese sind häufig nach der IEC 61131-2 Norm ausgebildet, die fordert, dass die Geräte auch ohne Spannungsversorgung für eine Zeitspanne von 10 ms uneingeschränkt funktionieren müssen. Wenn der beschriebene Testzyklus schneller als die angegebenen 10 ms abläuft, hat er folglich keinen Einfluss auf die Funktionsfähigkeit der angeschlossenen Geräte.

Entsprechend kann es vorteilhaft sein, einen fließenden Übergang der Schritte S1 bis S8 ohne Wartezeiten vorzusehen und/oder eine zu erwartende Anstiegsrampe der Ausgangsspannung Uᵢ der Stromversorgungseinheit 1 gemäß ihrem Zeitverhalten zu berücksichtigen.

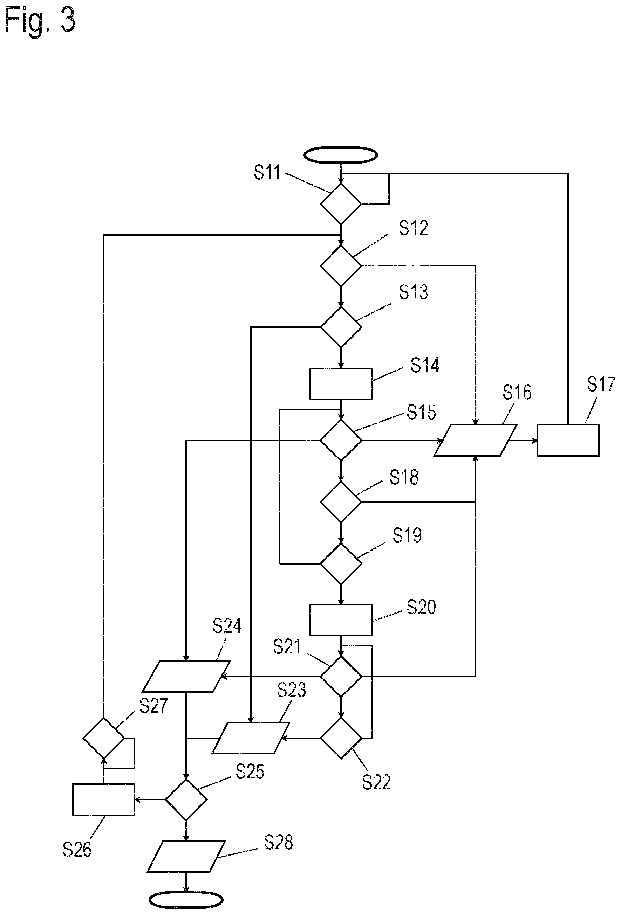

In Figur 3 ist ein weiteres Ausführungsbeispiel eines Überprüfungsverfahrens für einen Feldeffekttransistor eines ORing-Moduls ebenfalls eines Flussdiagramms dargestellt. Wiederum wird das Flussdiagramm mit Bezug auf die in Figur 1 schematisch wiedergegebene Stromversorgungsvorrichtung erläutert.

Ebenfalls wie im Zusammenhang mit Figur 2 erläutert, startet das Verfahren unter der Voraussetzung, dass die Stromversorgungseinheit 1 auf einen vorgegebene Nennspannung eingestellt ist, die am Ausgang 3 der Stromversorgungseinheit 1 anliegt.

Um das Verfahren mit dem Anschalten der Stromversorgungsvorrichtung starten zu können, ist über eine Schleifenstruktur im Schritt S11 zunächst eine gewisse Startverzögerung umgesetzt. Er nach Verstreichen einer vorgegebenen Zeit T > T_{Start} wird das Verfahren mit einem Schritt S12 fortgesetzt. Die Startverzögerung um die Zeit T Start ermöglicht es z.B. der Stromversorgungseinheit 1 hochzufahren und ihren stabilen Betrieb einzunehmen, falls diese erst kurz zuvor angeschaltet wurde.

Im Schritt S12 werden die Spannungen Uᵢ und Uₒ vor bzw. hinter dem ORing-Modul 10 gemessen und es wird überprüft, ob die Spannung am Ausgang 4 der Stromversorgungsvorrichtung selbst unter Berücksichtigung einer Messungenauigkeit von beispielsweise 0,05 V größer ist als am Ausgang der Stromversorgungseinheit 1. Bezogen auf die Spannungsdifferenz ΔU= Uᵢ - Uₒ wird also geprüft, ob |ΔU| > 0,05 V ist. Dieses kann z.B. von einer parallel geschalteten weiteren Stromversorgungseinheit herrühren, die trotz eingestellter gleich hoher Nennspannung eine leicht erhöhte Ausgangsspannung hat. Dass die Spannung Uₒ größer als Uᵢ ist, zeigt aber bereits, dass der FET 11 keinen Kurzschluss aufweist. Das Verfahren verzweigt dann zu einem Schritt S16, in dem der FET 11 als funktionsfähig angesehen wird.

Von dem Schritt S16 wird das Verfahren in einem Schritt S17 weitergeführt, in dem der FET 11 ggf. wieder eingeschaltet wird und eine Zeitspeichervariable wieder auf den Wert null gesetzt wird. Das Verfahren verzweigt dann zurück zum Schritt S11, in dem wiederum die Wartezeit T_{Start} abgewartet wird, bis erneut Schritt S12 abgearbeitet wird. Entsprechend kann über die Zeit T_{Start} auch eine Wiederholfrequenz für das Verfahren festgelegt werden.

Falls im Schritt S12 die Bedingung nicht erfüllt ist, beispielsweise falls die Spannung am Ausgang 3 genau gleich groß ist wie an den Ausgangsanschlüssen 4, verzweigt das Verfahren zu einem Schritt S13, in dem überprüft wird, ob die Spannung Uᵢ größer ist als die eingestellte Nennspannung der Stromversorgungseinheit 1. Wenn dieses so ist, ist es ein Zeichen dafür, dass die Stromversorgungsvorrichtung an ihren Ausgangsanschlüssen 4 mit einer höheren Spannung beaufschlagt ist und sich diese auch am Ausgang 3 der Stromversorgungseinheit 1 wiederfindet. Dieses ist ein Zeichen für einen Kurzschluss im FET 11, weswegen das Verfahren zu einem Schritt S23 verzweigt, in dem eine Variable, mit der eine Anzahl detektierter Fehlerfälle gezählt wird, um den Wert 1 inkrementiert wird und eine Zeit, zu der der Test stattgefunden hat, in einer Variable Tₜₑₛₜ abgespeichert wird.

Nach einem detektierten Fehler im Schritt S23 verzweigt das Verfahren zu einem Schritt S25, in dem überprüft wird, ob eine bestimmte Anzahl von Fehlerfällen, beispielsweise drei, erreicht ist. Falls nicht, verzweigt das Programm zu einem nächsten Schritt S26, in dem der FET 11 wieder eingeschaltet wird (falls er vorher abgeschaltet war), in dem der Testzeitpunkt (ggf. nochmals) in einer Variable T_{Test} abgespeichert wird und in dem (gegebenenfalls) die Spannung am Ausgang 3 der Stromversorgungseinheit 1 wieder auf den Nennwert zurückgesetzt wird.

Daraufhin wird in einem nächsten Schritt S27 eine Warteschleife ausgeführt, durch die das Verfahren erst nach Ablauf einer bestimmten Wartezeit erneut zum Schritt S12 verzweigt. Die Bedeutung dieser Wartezeit im Schritt S27 wird nachfolgend noch genauer erläutert.

Wenn die Bedingung im Schritt S13 nicht erfüllt war, wird das Verfahren mit einem Schritt S14 fortgeführt, in dem der FET 11 abgeschaltet wird. Der Zeitpunkt, zu dem das passiert, wird wiederum als Testzeitpunkt abgespeichert und der vor dem Abschalten fließende Strom wird ebenfalls gespeichert. Der Stromwert ist üblicherweise innerhalb der Stromversorgungseinheit 1 verfügbar, da er im Rahmen einer Überstromschutzschaltung von der Stromversorgungseinheit 1 gemessen wird. Das Abschalten des FET 11 im Schritt S14 entspricht dem Abschalten des Feldeffekttransistors im Schritt S1 des Ausführungsbeispiels von Figur 2.

In einem folgenden Schritt S15 wird die über dem FET 11 abfallende Spannung ΔU gemessen und bewertet. Dabei werden im vorliegenden Ausführungsbeispiel drei Fälle unterschieden: In einem ersten Fall ist die Spannung an den Ausgangsanschlüssen 4 um mehr als ein vorgegebener Spannungswert kleiner als die Spannung am Ausgang 3 der Stromversorgungseinheit 1, d.h. ΔU > U₂ , wobei U₂ ein positiver Wert von einigen Volt ist, beispielsweise 2 V. Wenn diese Bedingung erfüllt ist, bedeutet das, dass der FET 11 sperrt und auch seine Body-Diode nicht leitend ist. Dieses ist ein seltener aber möglicher Fehlerfall, der in einem Schritt S24 erfasst und gezählt wird. Nach dem Schritt S24 wird mit diesem Fehler in den Schritt S25 ff. ebenso umgegangen, wie bei einem Kurzschlussfehler des FET 11 im Schritt S23.

Ein weiterer Fall, der im Schritt S15 eintreten kann, ist dass der Betrag der Spannungsdifferenz ΔU kleiner ist als der genannte weitere Schwellenwert U₂ oder gleich diesem ist, aber im Betrag größer als oder gleich dem positive(n) ersten Schwellenwert U₁ von etwa 0,3 V, der auch Gegenstand der Abfrage in Schritt 3 in Figur 2 war. In dem Fall verzweigt das Verfahren zum Schritt S16, in dem der Feldeffekttransistor 11 als funktionsfähig angesehen wird. Das Verfahren kommt danach über den Schritt S17 und den Schritt S11 nach der Wartezeit T_{Start} zu einem neuen Durchlauf.

Im dritten Fall des Schritts S15 ist der Betrag der Spannungsdifferenz ΔU kleiner als der erste Schwellenwert U₁, i.e. |ΔU| < U₁, woraufhin das Verfahren mit dem Schritt S18 fortgeführt wird.

Im Schritt S18 wird erneut der am Ausgang der Stromversorgungseinheit 1 fließende Strom ermittelt. Wird festgestellt, dass der Strom vor dem Abschalten des FET 11 im Schritt S14 größer als ein vorgegebener Schwellenwert gewesen ist, jetzt aber auf null abgesunken ist, deutet auch dies auf eine korrekte Funktion und insbesondere auf ein korrektes Abschalten der Source-Drain-Strecke des Feldeffekttransistors hin. In diesem Fall verzweigt das Verfahren ebenfalls zum Schritt S16, in dem der FET 11 als funktionsfähig angesehen wird.

Wenn die Bedingung im Schritt S18 nicht erfüllt war, kann dieses an einer zu kurzen Zeit zwischen dem Schritt S14 und dem Schritt S18 liegen, die beispielsweise das Ergebnis der Strommessung im Schritt S18 verfälscht. Bis eine Mindestwartezeit erreicht ist, verzweigt das Verfahren daher in einen Schritt S19 zurück, um die Schritte S15 und S18 nochmals zu durchlaufen und damit erneut die Möglichkeit zu haben, dass der FET 11 im Schritt S16 als funktionsfähig angesehen wird. Wenn dieses auch bei wiederholtem Durchlauf nicht der Fall ist und im Schritt S19 festgestellt wird, dass die Abschaltzeit des FET 11 im Schritt S14 ausreichend lang zurückliegt, so dass auch unter Berücksichtigung von Zeitkonstanten der Messungen der Schritte S15 und S18 von korrekten Messungen auszugehen ist, verzweigt das Verfahren zu einem Schritt S20.

In dem Schritt S20 wird die Spannung am Ausgang 3 der Stromversorgungseinheit 1 um einen vorgegebenen Betrag, beispielsweise wieder um ein Volt hochgesetzt. Es schließen sich mit den Schritten S21 und S22 Schritte an, die analog zu den Schritten S15 und S19 sind: Im Schritt S21 werden wiederum für die Spannungsdifferenz ΔU drei verschiedene Fälle unterschieden, die genau den Unterscheidungen im Schritt S15 entsprechen. Das Verfahren verzweigt in dem ersten dort beschriebenen Fall (ΔU > U₂) zu dem Schritt S24 und in dem zweiten dort beschriebenen Fall (U₁ < |ΔU| <= U₂) zu dem Schritt S16. Nach ausreichender Wartezeit wird im dritten Fall, also dem Fall, dass sowohl die Messung im Schritt S15 als auch die Messung im Schritt S22 eine unterhalb des ersten Schwellenwerts liegende Spannungsdifferenz ergeben haben (ΔU < U₁), zum Schritt S23, in dem ein Kurzschluss des FET 11 diagnostiziert ist und als Fehler gezählt wird.

Wenn im Schritt S25 dann festgestellt wird, dass dieser Fehlerzustand reproduzierbar häufiger auftritt, beispielsweise mehr als zwei Mal, dann wird in einem Schritt S28 dieser Fehler auch nach außen signalisiert. Damit endet das Verfahren.

Nach Feststellung des Fehlers im Schritt S23 ausgehend vom Schritt S22 besteht prinzipiell noch die Möglichkeit, dass ein Fehler nur deswegen erkannt wurde, weil ein zweites parallel geschaltetes Netzteil, das mit der gleichen erfindungsgemäßen Fehlererkennung für dessen Feldeffekttransistor eines ORing-Moduls ausgestattet ist, durchlaufen wird und entsprechend genau synchron beim Ablaufen dieses Verfahrens im Schritt S20 seine Nennspannung hochgesetzt hat. In dem Fall würden beide Stromversorgungsvorrichtungen jeweils in ihrem Verfahren im Schritt S15 und im Schritt S21 eine Spannungsdifferenz von ΔU < U₁ messen.

Dieser Fall ist nicht unwahrscheinlich, wenn zwei gleiche Stromversorgungsvorrichtungen redundant ausgangsseitig aber auch eingangsseitig zusammengeschaltet sind und zum gleichen Zeitpunkt mit Eingangsspannung beaufschlagt werden, also gleichzeitig eingeschaltet werden. Mit einem gleichzeitigen Start der Stromversorgungsvorrichtungen starten auch die Überwachungsverfahren synchron.

Um zu verhindern, dass bei Wiederholung der Messung wiederum beide Stromversorgungsvorrichtungen ihre Messungen mit gleicher Zeitstruktur durchführen, ist die bereits angesprochene Wartezeit im Schritt S27 mit einer Zufallskomponente versehen.

Bevorzugt ist diese Zufallskomponente nicht rein rechnerisch (quasi zufällig), sondern verwendet in ihrem Algorithmus unterschiedliche Eigenschaften der Netzteile, beispielsweise deren Seriennummer, die für jedes Netzteil individuell ist. Auch können Zustände der niederwertigsten Bits von Analog-Digital-Wandlern als echte Zufallskomponenten innerhalb eines Algorithmus für einen Zufallszahlengenerator eingesetzt werden.

### Bezugszeichenliste

- 1: Stromversorgungseinheit
- 2: Eingangsanschluss
- 3: Ausgang
- 4: Ausgangsanschluss

- 10: ORing-Modul
- 11: Feldeffekttransistor (FET)
- 12: Steuereinheit
- 13: Steuerverbindung

- Uᵢ: Spannung am Ausgang der Stromversorgungseinheit
- Uₒ: Spannung an den Ausgangsanschlüssen der Stromversorgungsvorrichtung

- S: Source-Anschluss des FET
- D: Drain-Anschluss des FET
- G: Gate-Anschluss des FET

- S1 - S8: Verfahrensschritt
- S11-S28: Verfahrensschritt

## Patentansprüche

1. Verfahren zur Überprüfung mindestens eines als aktive Diode geschalteten Feldeffekttransistors (11), der innerhalb einer Stromversorgungsvorrichtung einem Ausgang einer Stromversorgungseinheit (1) nachgeschaltet ist, und dessen Schaltstrecke eine intrinsische oder externe Diode parallel geschaltet ist, aufweisend die folgenden Schritte:
- Erzeugen eines nicht vollständig leitenden, insbesondere sperrenden Zustands des mindestens einen Feldeffekttransistors (11);
- Erfassen eines ersten Werts eines Spannungsabfalls (ΔU) über einer Schaltstrecke des mindestens einen Feldeffekttransistors (11) bei einer ersten eingestellten Spannung der Stromversorgungseinheit (1);
- Einstellen einer zweiten Spannung der Stromversorgungseinheit (1);
- Erfassen eines zweiten Werts des Spannungsabfalls (ΔU) über der Schaltstrecke des mindestens einen Feldeffekttransistors (11) bei der zweiten eingestellten Spannung der Stromversorgungseinheit (1);
- Feststellen und signalisieren eines Defekts des mindestens einen Feldeffekttransistors (11), falls der erste Wert des Spannungsabfalls (ΔU) und der zweite Wert des Spannungsabfalls (ΔU) beide jeweils im Betrag kleiner als ein vorgegebener erster positiver Schwellenwert (U₁) sind, oder falls der erste Wert des Spannungsabfalls (ΔU) und/oder der zweite Wert des Spannungsabfalls (ΔU) größer als ein vorgegebener zweiter positiver Schwellenwert (Uₙ) sind, wobei der zweite Schwellenwert größer ist als der erste Schwellenwert.

2. Verfahren nach Anspruch 1, bei dem der erste Schwellenwert (U₁) etwa 0,3 Volt beträgt.

3. Verfahren nach Anspruch 1 oder 2, bei dem der zweite Schwellenwert (U₂) mindestens etwa 1,5 Volt beträgt.

4. Verfahren nach einem der Ansprüche 1 bis 3, bei dem die zweite Spannung um etwa 1 Volt größer ist als die erste Spannung.

5. Verfahren nach einem der Ansprüche 1 bis 3, bei dem die zweite Spannung um etwa den zweiten Schwellenwert (U₂) größer ist als eine gemessene Spannung an Ausgangsanschlüssen (4) der Stromversorgungsvorrichtung.

6. Verfahren nach einem der Ansprüche 1 bis 5, das wiederholt durchgeführt wird.

7. Verfahren nach Anspruch 6, bei dem ein Defekt des mindestens einen Feldeffekttransistors (11) erst dann signalisiert wird, wenn er in einer vorgegebenen Anzahl von Wiederholungen festgestellt wird.

8. Verfahren nach Anspruch 7, bei dem die vorgegebene Anzahl von Wiederholungen, nach denen ein Defekt auch signalisiert wird, mindestens drei beträgt.

9. Verfahren nach einem der Ansprüche 6 bis 8, bei dem zwischen zwei aufeinanderfolgenden Wiederholungen des Verfahrens eine Wartezeit liegt.

10. Verfahren nach Anspruch 9, bei dem die Wartezeit eine Zufallskomponente umfasst.

11. Stromversorgungsvorrichtung mit einer Stromversorgungseinheit (1), der mindestens ein als aktive Diode geschalteter Feldeffekttransistor (11) nachgeschaltet ist, **dadurch gekennzeichnet, dass** eine Steuereinheit (12) vorhanden ist, die zur Durchführung eines Verfahrens nach einem der Ansprüche 1 bis 10 eingerichtet ist.

12. Stromversorgungsvorrichtung nach Anspruch 11, bei der der mindestens eine Feldeffekttransistor (11) Teil eines ORing-Moduls (10) ist.

13. Stromversorgungsvorrichtung nach Anspruch 12, bei der die Stromversorgungseinheit und das ORing-Modul (10) in getrennten Gehäusen angeordnet sind.

14. Stromversorgungsvorrichtung nach Anspruch 12, bei der die Stromversorgungseinheit und das ORing-Modul (10) in einem gemeinsamen Gehäuse angeordnet sind.

15. Stromversorgungsvorrichtung nach Anspruch 14, bei der die das Verfahren durchführende Steuereinheit (12) Teil einer Steuereinrichtung der Stromversorgungseinheit (1) ist.

## Claims

1. Method for checking at least one field effect transistor (11) connected as an active diode, which is connected downstream of an output of a power supply unit (1) within a power supply device, and whose switching path has an intrinsic or external diode connected in parallel, comprising the following steps:
- generating a not fully conducting, in particular blocking state of the at least one field effect transistor (11);
- detecting a first value of a voltage drop (ΔU) across a switching path of the at least one field effect transistor (11) at a first set voltage of the power supply unit (1);
- setting a second voltage of the power supply unit (1);
- detecting a second value of the voltage drop (ΔU) across the switching path of the at least one field effect transistor (11) at the second set voltage of the power supply unit (1);
- detecting and signaling a defect of the at least one field effect transistor (11) if the first value of the voltage drop (ΔU) and the second value of the voltage drop (ΔU) are both smaller in magnitude than a predetermined first positive threshold value (U₁), or if the first value of the voltage drop (ΔU) and/or the second value of the voltage drop (ΔU) are larger than a predetermined second positive threshold value (Uₙ₎, wherein the second threshold value is larger than the first threshold value.

2. Method according to claim 1, in which the first threshold value (U₁) is about 0.3 volts.

3. Method according to claim 1 or 2, in which the second threshold value (U₂) is at least about 1.5 volts.

4. Method according to one of claims 1 to 3, in which the second voltage is higher than the first voltage by about 1 volt.

5. Method according to one of claims 1 to 3, in which the second voltage is higher than a measured voltage at output terminals (4) of the power supply device by approximately the second threshold value (U₂).

6. Method according to one of claims 1 to 5, which is carried out repeatedly.

7. Method according to claim 6, in which a defect of the at least one field effect transistor (11) is not signaled until it is detected in a predetermined number of repetitions.

8. Method according to claim 7, in which the predetermined number of repetitions after which a defect is also signaled is at least three.

9. Method according to one of claims 6 to 8, in which there is a waiting period between two successive repetitions of the method.

10. Method according to claim 9, in which the waiting time comprises a random component.

11. Power supply device having a power supply unit (1) downstream of which at least one field effect transistor (11) switched as an active diode is connected, **characterized in that** a control unit (12) is present which is set up to carry out a method according to one of claims 1 to 10.

12. Power supply device according to claim 11, in which the at least one field effect transistor (11) is part of an ORing module (10).

13. Power supply device according to claim 12, in which the power supply unit and the ORing module (10) are disposed in separate housings.

14. Power supply device according to claim 12, in which the power supply unit and the ORing module (10) are arranged in a common housing.

15. Power supply device according to claim 14, in which the control unit (12) performing the method is part of a control device of the power supply unit (1).

## Revendications

1. Procédé pour la vérification d'au moins un transistor à effet de champ (11) monté comme une diode active, qui est monté en aval d'une sortie d'une unité d'alimentation électrique (1) dans un dispositif d'alimentation électrique, et avec le trajet de commutation duquel une diode intrinsèque ou externe est montée en parallèle, comprenant les étapes suivantes :
- création d'un état non complètement conducteur, en particulier bloquant, de l'au moins un transistor à effet de champ (11) ;
- acquisition d'une première valeur d'une baisse de tension (ΔU) sur un trajet de commutation de l'au moins un transistor à effet de champ (11) à une première tension réglée de l'unité d'alimentation électrique (1) ;
- réglage d'une deuxième tension de l'unité d'alimentation électrique (1) ;
- saisie d'une deuxième valeur de la baisse de tension (ΔU) sur le trajet de commutation de l'au moins un transistor à effet de champ (11) à la deuxième tension réglée de l'unité d'alimentation électrique (1) ;
- détermination et signalisation d'un défaut de l'au moins un transistor à effet de champ (11) si la première valeur de la baisse de tension (ΔU) et la deuxième valeur de la baisse de tension (ΔU) sont toutes deux plus petites qu'une première valeur de seuil positive prédéterminée (U₁) ou si la première valeur de la baisse de tension (ΔU) et/ou la deuxième valeur de la baisse de tension (ΔU) sont plus grandes qu'une deuxième valeur de seuil positive prédéterminée (Uₙ), la deuxième valeur de seuil étant plus grande que la première valeur de seuil.

2. Procédé selon la revendication 1, dans lequel la première valeur de seuil (U₁) est d'environ 0,3 volt.

3. Procédé selon la revendication 1 ou 2, dans lequel la deuxième valeur de seuil (U₂) est d'au moins 1,5 volt environ.

4. Procédé selon l'une de revendications 1 à 3, dans lequel la deuxième tension est plus élevée d'environ 1 volt que la première tension.

5. Procédé selon l'une de revendications 1 à 3, dans lequel la deuxième tension est plus élevée d'environ la deuxième valeur de seuil (U₂) qu'une tension mesurée sur des connexions de sortie (4) du dispositif d'alimentation électrique.

6. Procédé selon l'une de revendications 1 à 5, qui est exécuté de façon répétée.

7. Procédé selon la revendication 6, dans lequel un défaut de l'au moins un transistor à effet de champ (11) n'est signalé que quand il est constaté dans un nombre prédéterminé d'itérations.

8. Procédé selon la revendication 7, dans lequel le nombre prédéterminée d'itérations après lesquelles un défaut est signalé est d'au moins trois.

9. Procédé selon l'une des revendications 6 à 8, dans lequel deux itérations successives du procédé sont séparées par un temps d'attente.

10. Procédé selon la revendication 9, dans lequel le temps d'attente inclut une composante aléatoire.

11. Dispositif d'alimentation électrique muni d'une unité d'alimentation électrique (1) en aval de laquelle est monté un transistor à effet de champ (11) monté comme une diode active, **caractérisé en ce qu'**est prévue une unité de commande (12) qui est agencée pour exécuter un procédé selon l'une des revendications 1 à 10.

12. Dispositif d'alimentation électrique selon la revendication 11, dans lequel l'au moins un transistor à effet de champ (11) fait partie d'un module ORing (10).

13. Dispositif d'alimentation électrique selon la revendication 12, dans lequel l'unité d'alimentation électrique et le module ORing (10) sont disposés dans des boîtiers séparés.

14. Dispositif d'alimentation électrique selon la revendication 12, dans lequel l'unité d'alimentation électrique et le module ORing (10) sont disposés dans un boîtier commun.

15. Dispositif d'alimentation électrique selon la revendication 14, dans lequel l'unité de commande (12) exécutant le procédé fait partie d'une installation de commande de l'unité d'alimentation électrique (1).
